# EUROPEAN PATENT SPECIFICATION

(11) **EP 3 951 895 B1**
(45) Date of publication and mention of the grant of the patent: **20.11.2024**
(21) Application number: 20783807.9
(22) Date of filing: 23.01.2020
(51) Int. Cl.: H01L 33/38, H01L 33/44, H01L 33/62

(54) **SEMICONDUCTOR LIGHT-EMITTING DEVICE**
LICHTEMITTIERENDES HALBLEITERBAUELEMENT
DISPOSITIF ÉLECTROLUMINESCENT À SEMI-CONDUCTEURS

(30) Priority: 03.04.2019 CN 201910266574
(43) Date of publication of application: 09.02.2022
(73) Proprietor: Quanzhou Sanan Semiconductor Technology Co., Ltd., Quanzhou, Fujian 362343 (CN)
(72) Inventor: ZHU, Liqin, Xiamen, Fujian 361009 (CN); LIN, Daquan, Xiamen, Fujian 361009 (CN); YANG, Lixun, Xiamen, Fujian 361009 (CN); YU, Cheng, Xiamen, Fujian 361009 (CN)
(74) Representative: Bals & Vogel Patentanwälte PartGmbB
(86) International application number: PCT/CN2020/074015
(87) International publication number: WO 2020/199746

(56) References cited:
- EP-A1- 3 062 355
- CN-A- 101 867 002
- CN-A- 106 409 997
- CN-A- 110 021 691
- CN-U- 208 208 785
- KR-A- 20150 029 423
- US-A1- 2008 237 622
- US-A1- 2009 039 359
- US-A1- 2012 025 250
- US-A1- 2013 256 735
- US-A1- 2018 254 384
- US-A1- 2019 067 525

## Description

### TECHNICAL FIELD

The present invention relates to a semiconductor light-emitting device, and more specifically, to a semiconductor light-emitting device capable of performing operation at high currents and improving light-emitting efficiency by changing electrode arrangement.

### BACKGROUND OF THE INVENTION

Semiconductor light-emitting devices include materials that emit light. They are widely used in applications such as lighting devices, display devices, and light sources. Typically, a semiconductor junction light-emitting devices have a P-type semiconductor and an N-type semiconductor junction, and an active layer is formed between the two types of semiconductors to excite light emission. In the semiconductor structure, light can be emitted by compounding electrons and holes at regions of the two types of semiconductors. Depending on the position of the electrodes of the semiconductor layer, the semiconductor junction light-emitting device includes vertical structures or horizontal structures. The horizontal structures include a face-up structure, a vertical structure, and a flip-chip structure. However, for good current expansion under a high current density demand, a large contact area between the electrodes and the epitaxial semiconductor is required. The increase in the electrode area of the conventional face-up structure and vertical structure leads to a reduction in the light-emitting surface, and the substrate of the flip-chip structure may absorb light. Considering this, by supporting the back side of the semiconductor sequence through a support substrate and locating the PN electrodes between the support substrate and the semiconductor, the PN electrodes are all led out from the back side of the light-emitting semiconductor sequence, which ensures good expansion of the large current without the electrodes blocking the light emission.

EP 3062355 A1, US 2013/256735 A1, US 2018/254384 A1, and US 2012/025250 A1 disclose a semiconductor light emitting device including a substrate, a semiconductor light emitting layer sequence, a first and second electrode, a first and second electrical connection layer, and an insulating layer between the first and second electrical connection layer, wherein the insulating layer includes a via and the second electrical connection layer extends through the via.

### SUMMARY OF THE INVENTION

The invention provides a semiconductor light emitting device as defined in the appended set of claims.

### BRIEF DESCRIPTION OF THE DRAWINGS

FIG. 1 is a schematic diagram of the structure of the semiconductor light-emitting device of the embodiment I.
FIGS. 2-11 are schematic diagrams of the structures obtained in each step of the method of making the semiconductor light-emitting device of the embodiment I.
FIGS. 12-13 are schematic diagrams of the structures obtained during the process of the making method of the embodiment II.
FIG. 14 is a schematic diagram of the structure of the semiconductor light-emitting device of the embodiment III.
FIG. 15 is a schematic diagram of the structure of the semiconductor light-emitting device of the embodiment IV.
FIGS. 16-18 are schematic diagrams of the structure of the semiconductor light-emitting device of a comparative example not forming part of the present invention.

### DETAILED DESCRIPTION

The following is a detailed description of the light-emitting diode structure of the present invention in combination with the accompanying drawings, so that the process of realizing how the present invention applies technical means to solve technical problems and achieve technical effects can be fully understood and implemented accordingly. It should be noted that, as long as they do not constitute a conflict, the various embodiments of the present invention and the various features in each embodiment can be combined with each other, and the resulting technical solutions are within the scope of the present invention as defined by the claims.

An embodiment provides a semiconductor light-emitting device as follows. The semiconductor light-emitting device may be a chip structure, a packaged structure including a chip structure, or an application that includes a package structure mounted on a circuit board and having a chip structure, or includes a chip structure mounted directly on a circuit board.

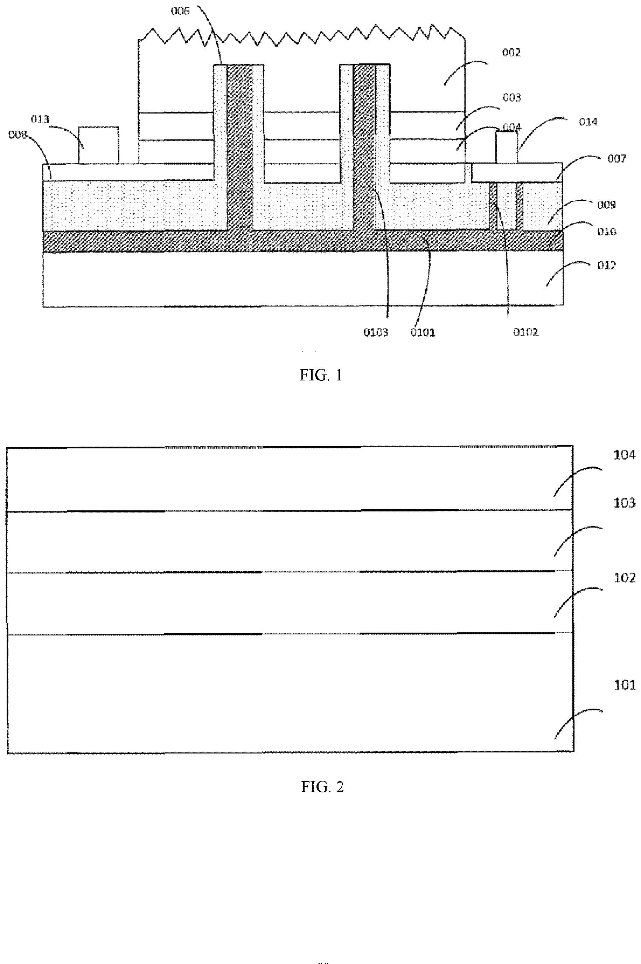

As shown in FIG. 1, the semiconductor light-emitting device of this embodiment is a chip structure including a substrate 012 and a multi-layer structure on the substrate 012. The multi-layer structure includes a second electrical connection layer 010, an insulating layer 009, a first electrical connection layer 008, and a semiconductor light-emitting sequence in order from the substrate side.

The substrate 012 is used to carry the semiconductor light-emitting sequence. The substrate 012 can be an insulating substrate, such as aluminum nitride, aluminum oxide, etc., or a conductive substrate, such as silicon, silicon carbide, metal or metal alloy, such as copper, copper tungsten, etc. The semiconductor light-emitting sequence includes a first conductivity type semiconductor layer 004, light-emitting layer 003 and a second conductivity type semiconductor layer 002, and the first conductivity type and the second conductivity type are N-type or P-type, respectively. The first conductivity type semiconductor layer 004 and the second conductivity type semiconductor layer 002 respectively provide electrons or holes to the light-emitting layer. The light-emitting layer is a layer that at least provides semiconductor light-emitting radiation.

The second electrical connection layer 010 includes a single-layer or a multi-layer stacked conductive layer electrically connected to the second conductivity type semiconductor layer 002. The second electrical connection layer 010 may be formed of at least any of or any combination of metal, metal alloy or inorganic compound conductive materials. The second electrical connection layer 010 may also be used to connect the semiconductor light-emitting sequence to one side of the substrate, thus can also include a bonding layer (not shown in the figures) for the connection between the second electrical connection layer side and the substrate. The bonding layer material can be a single layer or multiple layers, with conductive materials such as metal or metal alloy. However, the bonding layer can also be an insulating bonding layer formed by at least one of a number of inorganic compound materials, such as silicon oxide, silicon carbide or aluminum oxide, and when the bonding layer is an insulating layer, the bonding layer is not included in the conductive layer of the second electrical connection layer 010.

The insulation layer 009 includes at least one layer of dielectric material, generally formed by materials such as inorganic nitrides, oxides or fluorides, such as silicon oxide, silicon nitride or zinc oxide, for at least the insulation between the second electrical connection layer 010 and the first electrical connection layer 008.

The first electrical connection layer 008 includes a single-layer or a multi-layer conductive layer located at one side of the first conductivity type semiconductor layer 004 and in electrical contact with the first conductivity type semiconductor layer 004, and is electrically connected to a first electrode. The first electrical connection layer 008 may be formed of at least any of or any combination of metal, metal alloy or inorganic compound conductive materials. The first electrical connection layer 008 may further include a reflective layer that is capable of reflecting light radiation from the light-emitting layer with a reflectivity of at least 50%. The reflective layer is formed of materials with a high reflectivity, such as a reflective metal (e.g. Ag, Al, Au) or a combination of a reflective metal and a light-transmissive inorganic compound layer (e.g. ITO).

At least one hole 006 opens from one side of the first conductivity type semiconductor layer 004 and extends through the first conductivity type semiconductor layer 004 and the light-emitting layer 003 to the second conductivity type semiconductor layer 002. At the bottom of the hole 006 is the second conductivity type semiconductor layer 002. The at least one hole 006 includes one or more holes. The first electrical connection layer 008 is located at one side of the first conductivity type semiconductor layer 004, not covering the opening of the hole 006. The insulating layer 009 is located between the first electrical connection layer 008 and the second electrical connection layer 010, and extends from the opening of the hole 006 that is not covered by the first electrical connection layer 008 and covers a side wall inside the hole 006 with the bottom of the hole 006 exposed.

A first electrode 013 for wire bonding is electrically connected to the first conductivity type semiconductor layer 004 through first electrical connection layer 008.

A second electrode 014 for wire bonding is electrically connected to the second conductivity type semiconductor layer 002 through the second electrical connection layer 010.

Specifically, according to the distribution position, the second electrical connection layer 010 can be divided to include a first portion 0101, a second portion 0102, and a third portion 0103. The first portion 0101 includes a portion with a certain thickness located at a side of the insulating layer 009 away from the semiconductor light-emitting sequence.

The second portion 0102 of the second electrical connection layer 010 extends through the insulating layer 009 by filling in the vias in the insulating layer 009. The openings of the vias in the insulating layer 009 is not located at a center position vertically below the second electrode 014. That is, the vias in the insulating layer offset from the center position vertically below the second electrode, so that the second portion 0102 of the second electrical connection layer 010 that fills in the vias of the insulating layer 009 is not located at the center position vertically below the second electrode 014.

Preferably, the via of the insulating layer 009 has an annular opening, and the insulating layer surrounded by the annular opening serves as a support for the second electrode 014. Alternatively, the insulating layer 009 has a plurality of vias, and the insulating layer among the plurality of the vias serves as a support for the second electrode 014.

Preferably, the opening of the via of the insulating layer 009 is located below the second electrode closer 014 to the edge relative to the center, or partially located vertically below the second electrode 014, or not located vertically below the second electrode 014.

More preferably, the surface below the second electrode 014 overlaps the surface of the insulating layer 009 by at least half a radius from the center to the edge.

More preferably, the ratio of the area under the second electrode 014 to the area of the second portion 0102 of the second electrical connection layer 010 is at least 4/5, or the areas of both are close or equal.

On the one hand, the via of the insulating layer 009 is designed to be an annular in shape or a multi-via type, so that the insulating layer structure can be retained at the center position vertically below the second electrode 014 and the area near the center position where the wire bonding force is the largest, and the insulating layer forms a strong support for the second electrode 014 against the wire bonding force, replacing the traditional non-dense metal material which is filled in the openings of a columnar via of the insulating layer below the second electrode and serves as a support for wire bonding. So it can thus address the issue of abnormalities such as collapse or split of the second electrode 014.

On the other hand, the via has an annular shape, and without changing the opening area of the via in the insulating layer 009, the width of the via is reduced compared to the horizontal width of a conventional via with a columnar opening. The second portion 0102 of the second electrical connection layer 010 is formed of the metal filled in the via. The denseness of the metal filled in the via will be improved and the voids in the metal will be reduced, which can help address the issue of collapse and abnormal wire bonding caused by the collapse during the wire bonding process for the second electrode 014.

The third portion 0103 fills the hole 006 to the bottom of the hole 006 and is in electrical contact with the second conductivity type semiconductor layer 002. A covering portion of the insulating layer 009 on the side wall of the hole 006 is used for electrical insulation between the first portion 0101 of the second electrical connection layer 010 and the light-emitting layer 003 and the first conductivity type semiconductor layer 004 of the semiconductor light-emitting sequence. The second portion 0102 extends from the first portion 0101 through the insulating layer 009 to the same side as the first electrical connection layer 008 for electrically connecting the second electrode 014. A third electrical connection layer 007 is provided between the surface of the second portion 0102 of the second electrical connection layer 010 and the second electrode 014. One side of the third electrical connection layer 007 is in contact with the second portion 0102 of the second electrical connection layer 010, and the other side is used for the preparation of the second electrode 014. The third electrical connection layer 007 may be formed using the same procedure as the first electrical connection layer 008, or may have the same material as the structure of at least some of the layers of the multi-layer material of the first electrical connection layer 008. The third electrical connection layer 007 is electrically insulated from the first electrical connection layer 008.

### Embodiment I

The structure of the semiconductor light-emitting device of this embodiment is illustrated below in conjunction with the making method thereof. FIGS. 2-11 show a schematic diagram of the structures obtained at each step in the making method of a semiconductor light-emitting device of this embodiment.

Firstly, a semiconductor epitaxial layer is provided. As shown in Figure 2, the semiconductor epitaxial layer includes a growth substrate 101, a semiconductor light-emitting sequence. The growth substrate can be an epitaxial growth substrate such as sapphire, silicon or gallium phosphide, gallium arsenide, indium phosphide and other substrates that can be used to grow the semiconductor light-emitting sequence. Sapphire is preferable in this embodiment.

The semiconductor light-emitting sequence includes a second conductivity type semiconductor layer 102, a light-emitting layer 103 and a first conductivity type semiconductor layer 104. The first type and the second type are N-type or P-type, respectively, to form different conductivity. The semiconductor light-emitting sequence is a gallium nitride (Al or In elements may be added) based semiconductor material, emitting ultraviolet, blue or green light with a light-emitting wavelength between 200 and 550 nm, or an aluminum gallium indium phosphorus or aluminum gallium arsenic based semiconductor material, emitting yellow, orange, red or infrared light with a light-emitting wavelength between 550 and 950 nm.

In order to achieve lattice matching between the semiconductor light-emitting sequence and the growth substrate 101 and the removal of the growth substrate 101, it is optional to preferentially grow a buffer layer, a transitional layer or an etch-stop layer, etc. on the growth substrate 101. The semiconductor light-emitting sequence of the embodiment is a made of gallium nitride based semiconductor material.

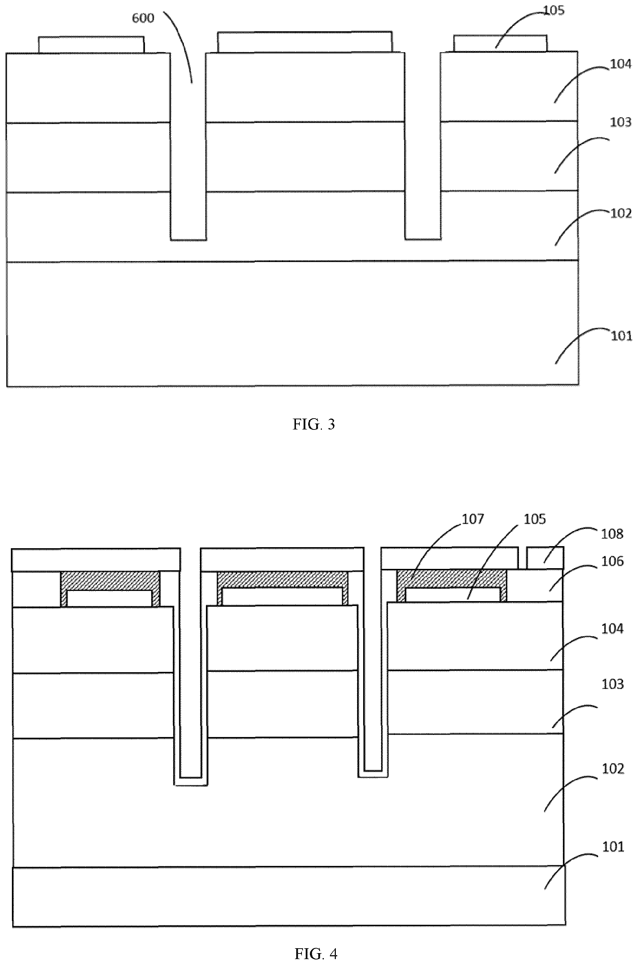

As shown in FIG. 3, holes 600 are opened on one side of the semiconductor light-emitting sequence. The opening of the holes 600 is located on the side where the first conductivity type semiconductor layer 104 is located. The hole 600 extends through the first conductivity type semiconductor layer 104 and the light-emitting layer 103 until its bottom reaches the second conductivity type semiconductor layer 102. The number of the holes 600 is 1 to 50,000. Preferably, there are a plurality of the holes 600 with the same size and the same spacing therebetween, or different sizes or spacing therebetween. The distance between the centers of adjacent holes 600 is 5 to 500 µm. The size of hole 600 is 1 to 100 µm. The ratio of the total area of the holes 600 to the area of the first conductivity type semiconductor layer 104 is 0.5 to 20%.

A first electrical connection layer is made. The first electrical connection layer is covered on the side of the first conductivity type semiconductor layer 104 and is electrically connected to the first conductivity type semiconductor layer 104. The first electrical connection layer is made of a single layer or multiple layers of conductive material. The conductive material may be a metal, a metal alloy, a conductive metal oxide or a combination thereof, such as gold, silver, aluminum, nickel, titanium, platinum, chromium or other metals, etc., and an alloy of at least one of them, or a conductive oxide layer such as IZO, ITO, etc.

More preferably, as shown in FIG. 3, the first electrical connection layer includes an ohmic contact layer 105 providing ohmic contact with the first conductivity type semiconductor layer. Specifically, the ohmic contact layer 105 is made using, for example, a transparent conductive metal oxide, specifically such as ITO or GZO, or using a thin layer of a metal such as aluminum, chromium or titanium. The thickness of the ohmic contact layer 105 is 1 to 100 nm, preferably between 1 to 20 nm or 1 to 10 nm.

As shown in FIG. 4, the first electrical connection layer may also include a reflective layer 107 having a reflective function. The reflective layer 107 may be provided on the ohmic contact layer 105. The reflective layer 107 includes at least a reflective metal or a combination of a reflective metal and a transparent inorganic compound medium. The reflective metal may be at least one metal with high reflectivity such as aluminum, gold, silver, etc., and the transparent inorganic compound medium may be a material such as oxide, nitride, ITO or IZO. The reflective layer 107 can reflect the light radiated from the light-emitting layer to one side of the first electrical connection layer effectively with a reflectivity of at least 50%, and more preferably, a reflectivity of more than 80%. The total thickness of the reflective layer 107 can be 50 nm to 500 nm.

Preferably, as shown in Figure 4, an additional passivation layer 106 may be provided between the first electrical connection layer and one side of the semiconductor light-emitting sequence. The passivation layer 106 covers at least the side of the semiconductor light-emitting sequence, or may further extend to the side walls and bottom of the holes 600. The passivation layer 106 can be made after the formation of the ohmic contact layer 105 and before the formation of the reflective layer 107. The passivation layer 106 can be nitride or oxide, such as silicon oxide or silicon nitride. One or more openings of the passivation layer 106 are needed to expose the ohmic contact layer 105. At least the reflective layer 107 of the first electrical connection layer fills the opening of the passivation layer 106 to contact with one side of the ohmic contact layer 105.

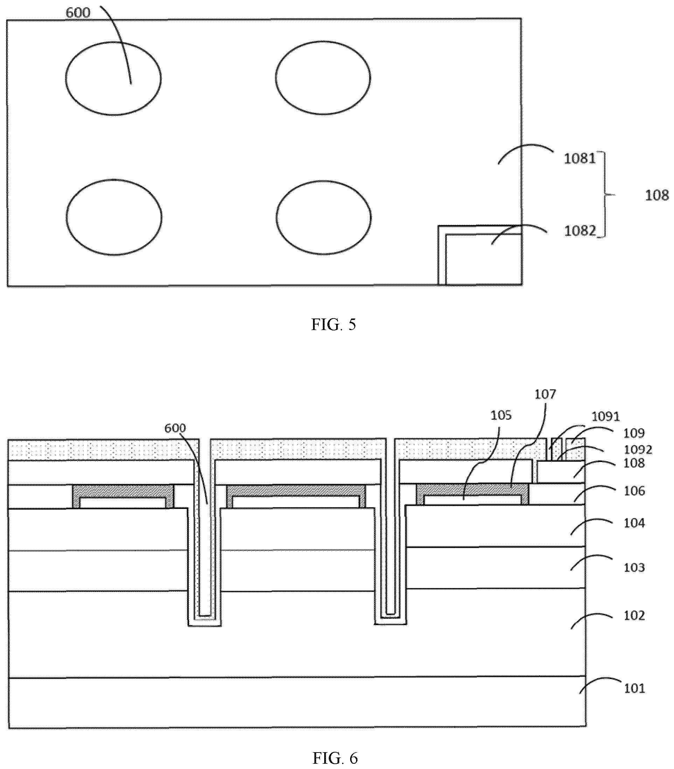

As shown in FIGS. 4-5, the first electrical connection layer may also include a metal barrier layer 108 formed after the reflective layer 107 to prevent the diffusion of reflective metals such as aluminum or silver. The metal barrier layer 108 includes, but not limited to, at least one of Pt, Au, Cr, Ti and other metals, and the overall thickness can be 100 to 1000 nm. The metal barrier layer 108 can be formed to include two portions simultaneously at one side of the semiconductor light-emitting sequence, i.e. The first portion 1081 and the second portion 1082 that are spaced from each other in the horizontal direction with a separation region formed. The first portion 1081 of the metal barrier layer 108 is part of the first electrical connection layer, and the second portion 1082 of the metal barrier layer 108 is a third electrical connection layer defined in this embodiment. There is a gap between the first portion 1081 and the second portion 1082 of the metal barrier layer 108, and the gap is subsequently filled by an insulating layer to achieve insulating isolation. The first portion 1081 of the metal barrier layer 108 is covered with a reflective layer 107. As shown in the schematic diagram of a planar structure in FIG. 5, the metal barrier layer 108 may be formed to include the first portion 1081 and the second portion 1082 to ensure that the subsequent first and second electrodes are at the same height to facilitate wire bonding.

As shown in FIG. 6, an insulating layer 109 is formed to cover the bottom of the hole 600, the side walls of the hole 600, and one side of the metal barrier layer 108 of the first electrical connection layer, and is filled to the separation region between the first portion 1081 and the second portion 1082 of the metal barrier layer 108 of the first electrical connection layer. The insulating layer 109 may be made by a CVD process. The material of the insulating layer 109 may be the same as or different from the material of the passivation layer 106, and specifically, it may be an oxide or nitride, such as silicon oxide, silicon nitride or zinc oxide which are electrically insulating materials. The thickness of the insulating layer 109 at the side of the first electrical connection layer is 100 nm to 5000 nm, or preferably 500 nm or more, or for example 600 to 1000 nm.

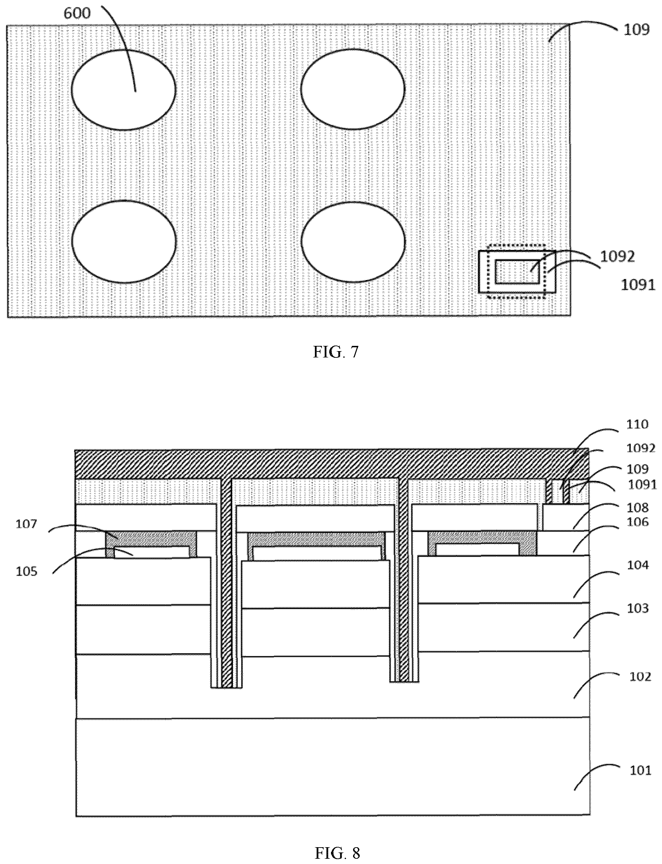

After the formation of the insulating layer 109, the insulation layer 109 and the passivation layer 106 at the bottom of at least part of the holes 600 are removed by an etching process to expose the second conductivity type semiconductor layer 102. The etching process may be BOE etching. At the same time, the portion of the insulating layer 109 corresponding to a position (as marked by the dashed line in FIG. 7) where a subsequent second electrode 114 is to be formed is etched to form a through via 1091. The through via 1091 is located on the portion of the insulating layer 109 above the second portion 1082 of the metal barrier layer 108 of the first electrical connection layer. The through via 1091 is annular, columnar or conical, and the number is one or more. The annular shape is open or closed. The via 1091 is located above the second portion 1082 of the metal barrier layer 108.

FIG. 7 is a top view from one side of the insulating layer 109 in FIG. 6. In this embodiment, the through via 1091 is designed as a closed annular structure that surrounds a separate insulating layer block1092. The area marked by the dashed line in the figure will be covered by the second electrode. One side of the separate insulating layer block 1092 will be used to provide main or total support to the second electrode, i.e., the separate insulating layer block 1092 will be designed to be located below the second electrode in subsequent steps. As the surface side of the second electrode receives an external force during the wire bonding, the external force is mainly concentrated at the center of the second electrode. According to the present invention, the separate insulating layer block 1092 can be used to resist the main wire-bonding force from the wire-bonding electrode (e.g. gold ball). The annular via will be used to be filled by the second portion of the second electrical connection layer. The annular via 1091 offsets from a center position below the second electrode and is located around the separate insulating layer block 1092, so that even if there are voids due to the uniformly filling, the second portion of the second electrical connection layer has a smaller part subjected to the wire-bonding force, or is not subjected to the vertical wire-bonding force, and the collapse of the second portion of a conventional second electrical connection layer, which leads to abnormal wire bonding, can be avoided as much as possible.

In order to form an effective support for the second electrode, the insulating layer 109 is preferably at least one of the following oxide or nitride ceramics: silicon oxide, silicon nitride or aluminum oxide, etc., more preferably silicon nitride in this embodiment. The insulation layer 109 preferably has a Mohs hardness of at least 6, more preferably at least 7 or at least 8. The formation process used may be CVD. Based on this design, preferably, the separate insulating layer block 1092 is preferably designed such that an at least half the radius from the center to the edge of the bottom surface of the second electrode in the final structure overlaps with the surface of the separate insulating layer block 1092, when viewed from the side of the second electrode, or preferably, the ratio of the areas of the surfaces of the separate insulating layer block 1092 and the second electrode facing each is at least 1/4. More preferably, the area of the separate insulating layer block 1092 is at least 1/2 or at least 4/5, or the former is at least 5/6 of the latter, or both are at most equal. The annular via 1091 may have an opening size of 10 microns or more. The area of the opening of the annular via 1091 is reasonably designed and adjusted according to the actual size of the second electrode.

As shown in FIG. 8, the second electrical connection layer 110 is then formed. According to different positions, the second electrical connection layer 110 includes a first portion, a second portion, and a third portion. The first portion covers a side of the insulating layer 109 away from the semiconductor light-emitting sequence. The second portion is filled into the annular via 1091 of the insulating layer 109 to achieve electrical connection with the second electrode subsequently formed. electrical connection layerThe third portion connects the first portion, and is filled into the holes 600 from the opening of the hole to the bottom of the hole 600 and is in direct contact with the second conductivity type semiconductor layer. The first portion, the second portion and the third portion include the same material.

The second electrical connection layer 110 may be a single layer or multiple layers of conductive material including at least ohmic contact material capable of forming ohmic contact with the second conductivity type semiconductor layer 102. Specifically, the ohmic contact material may be a single or multiple layers of metal or metal alloy, such as at least one layer of aluminum, nickel or aluminum-chromium, or includes transparent inorganic compound conductive material, such as IZO or ITO material. Aluminum-chromium is preferable in this embodiment, and the thickness of aluminum-chromium is routinely selected according to the actual ohmic contact effect. The thickness of the aluminum chromium is 100 nm to 500 nm. The ohmic contact material covers at least one side of the insulating layer 109, the side walls and bottom of the holes 600 of the insulating layer 109, and at least the side wall and bottom of the annular via 1091 of the insulating layer 109.

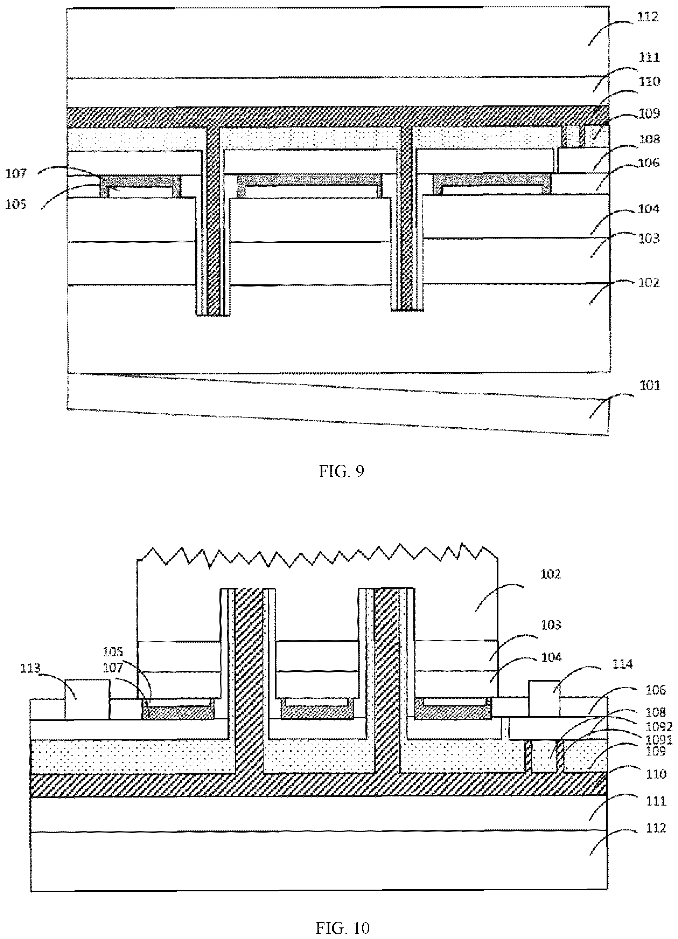

The second electrical connection layer 110 may also include other metal layers filled in the holes and the annular via 1091 and having a certain thickness at one side of the insulating layer 109. Specifically, as shown in the schematic diagram of a structure in FIG. 9, a bonding layer 111 used for the connection between the substrate 112 and the second electrical connection layer 110 is formed at one side of the insulation layer 109 away from the second electrical connection layer 110. The bonding layer 111 covers a surface of the ohmic contact layer. Alternatively, the bonding layer can also be filled in the annular via 1091.

The substrate for support is then attached to one side of the bonding layer 111. The substrate 112 can be an insulating substrate such as aluminum nitride, aluminum oxide, etc., or a conductive substrate such as a silicon substrate or a metal substrate. The process of the connection can be a bonding process, and the bonding process can specifically include bonding by bonding layer 111. The bonding layer 111 can be a multi-layer metal or metal alloy, such as one or a combination of gold-tin, nickel-tin, titanium-nickel-tin, or other conventional bonding materials. The bonding process is a high temperature bonding process.

As shown in FIG. 10, the growth substrate 101 is then removed. Depending on the material, the growth substrate 101 can be removed by the processes such as grinding and thinning, laser stripping, wet etching, dry etching or the combination thereof. For example, the sapphire substrate is preferably removed by grinding and thinning or laser stripping, and the GaAs-based substrate is removed by wet etching.

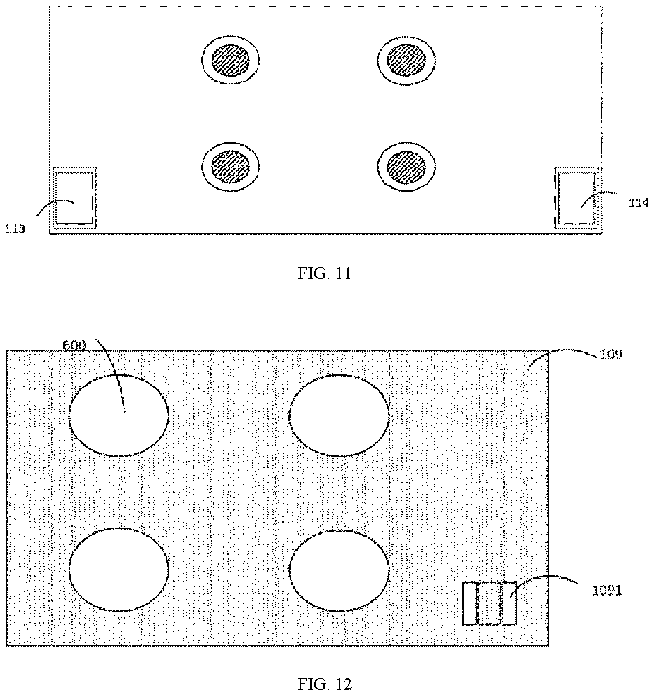

Next, as shown in FIG. 11, the semiconductor light-emitting sequence is etched from the side where the second conductivity type semiconductor layer 102 is located until part of the first portion of the metal barrier layer 108 that serves as the first electrical connection layer, the second portion of the metal barrier layer 108 that is the third electrical connection layer and a separation region are exposed. The exposed surface of the first portion is used for the formation of the first electrode and the exposed surface of the second portion is used the formation of the second electrode. The surface of the second conductivity type semiconductor layer 102 of the semiconductor light-emitting sequence can be roughened to form an light-emitting surface to improve the light-emitting efficiency, and the top and/or side walls of the light-emitting surface of the semiconductor light-emitting sequence can be formed with a light-transmissive protective layer, and the protective layer can include a material such as silicon oxide, silicon nitride, etc., to provide electrical insulation or water vapor protection.

The first electrode 113 and the second electrode 114 can respectively be a single electrode or at least two electrodes. And the first electrode 113 and the second electrode 114 are formed on the exposed portion of the first electrical connection layer and the surface of the third electrical connection layer, respectively, which can ensure that the first electrode 113 and the second electrode 114 are at the same height to facilitate the subsequent wire bonding process. The annular via of the insulating layer is located below the second electrode 114, and surrounds the separate insulating layer block 1092. The opening of the annular via 1091 of the insulating layer offsets from the center position vertically below the second electrode 114. The number of the first electrode 113 and the number of the second electrode 114 is one respectively, as shown in the structure schematic diagram in FIG. 11, viewing from the top of one side where the light-emitting surface of the semiconductor light-emitting sequence is located.

Finally, a single semiconductor light-emitting device with completely separated sidewalls and bottom is formed from the semiconductor light-emitting sequence to the support substrate 112 by a separation process. The separation process includes an etching process for the semiconductor light-emitting sequence, the first electrical connection layer, the insulating layer and the second electrical connection layer, and a cutting process for the substrate.

### Embodiment II

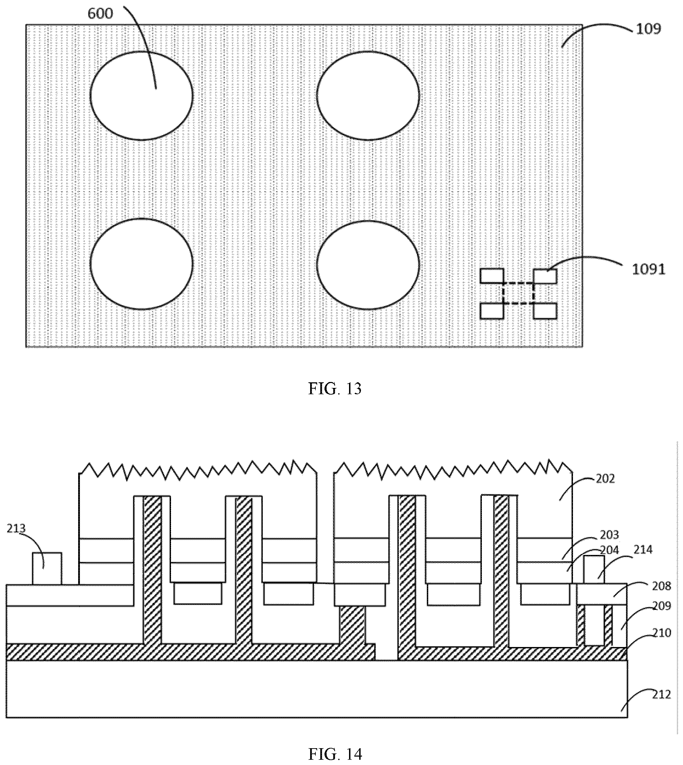

As an alternative to the embodiment I, a structural design to solve the problem of a hole appearing below the second electrode after the wire boding is provided. The insulating layer 109 has two vias instead of one via in the conventional structure. Further preferably, as shown in FIG. 12 (an alternative embodiment of figure 7), the number of vias are two and the two vias have a certain distance to allow for an insulating layer with a certain width located between the vias. The area of the insulating layer between the two vias (roughly the region marked by the dashed frame in the figure) is used to provide a major support or a complete support to the second electrode. That is, the insulating layer 109 is at the center positon vertically below the second electrode in the final structure obtained by the above changes, or further, vertically below the second electrode is mainly the insulating layer 109 or entirely the insulating layer 109. Preferably, the two vias are separated by a distance greater than or equal to half the radius of the lower surface of the second electrode. The overall area of the vias is the same as the overall area of the annular vias in the embodiment I or the overall area of the conventional vias. Or as an alternative embodiment of FIG. 10, as shown in FIG. 13, the number of vias is four and there is a distance between the vias. The area of the centrally located insulating layer enclosed by the four vias (dashed frame position in the figure) has an area ratio of at least 1/4, at least 1/2 or equal to the area of the lower surface of the second electrode. The insulating layer enclosed by the vias (dashed frame position in the figure) will be used to provide support or main support to the second electrode, i.e., the insulating layer is at the center position vertically below the second electrode, or further, vertically below the second electrode is mainly the insulating layer or entirely the insulating layer. On the other hand, without changing the opening area of the vias in the insulating layer, a plurality of vias are provided and the opening width of each of the plurality of vias is reduced relative to the horizontal width of a conventional via with a columnar opening. The metal filled in the vias forms the second portion of the second electrical connection layer. The denseness of the metal filled in the via will be improved and the voids in the metal will be reduced, which can help address the issue of collapse and abnormal wire bonding caused by the collapse during the wire bonding process for the second electrode.

### Embodiment III

As an alternative to Example I, as shown in FIG. 14, the substrate 212 may further include at least two semiconductor light-emitting sequences electrically connected in series, but structurally at least sidewalls thereof are separated. Each semiconductor light-emitting sequence includes a first conductivity type semiconductor layer 204, a light-emitting layer 203, and a second conductivity type semiconductor layer 202. Each semiconductor light-emitting sequence has a separate first electrical connection layer 208 and a second electrical connection layer 210 between the bottom of the semiconductor light-emitting sequence and the substrate 212. The first electrical connection layer 208 and the second electrical connection layer 210 are insulated and isolated by an insulating layer 209. A bonding layer that is part of the second electrical connection layer 210 may be used to form a connection between the substrate 212 and the second electrical connection layer 210. In order to achieve a series connection, the first electrical connection layer 208 of one semiconductor light-emitting sequence is connected to the second electrical connection layer 210 of an adjacent semiconductor light-emitting sequence. The specific connection includes that a hole is made in the insulating layer below the first electrical connection layer 208 of one semiconductor light-emitting sequences, and the second electrical connection layer 210 of an adjacent semiconductor light-emitting sequence extends to fill in the hole in the insulating layer and contacts with the first electrical connection layer 208 of the previous semiconductor light-emitting sequence, so as to realize the series connection of two adjacent semiconductor light-emitting sequences. The first semiconductor light-emitting sequence in series has a first electrode 213 at one side connected to the first electrical connection layer, and the last semiconductor light-emitting sequence in series has a second electrode 214 connected to the second electrical connection layer. The first electrode 213 and the second electrode 214 are located on the same side.

### Embodiment IV

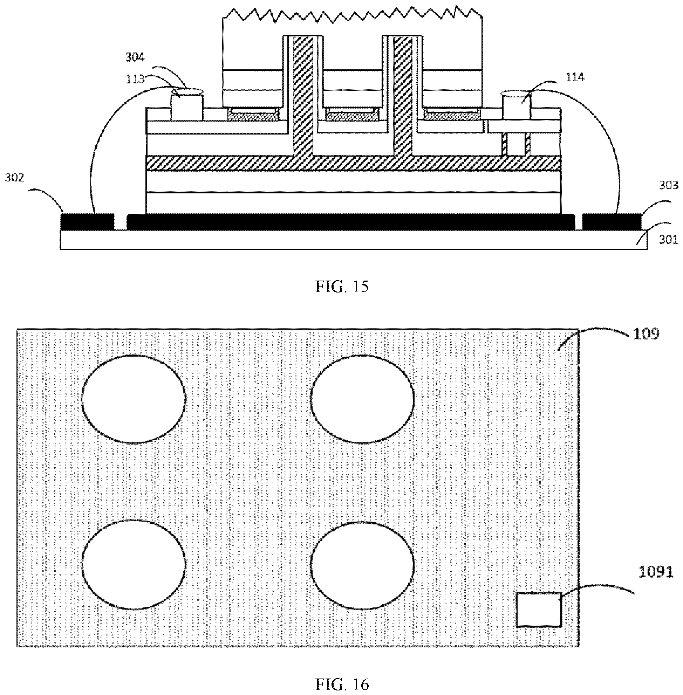

The semiconductor light-emitting device of the present invention can be used to make packaged products, or used in the applications in the field of lighting or display with high current demand which are widely used, such as backlighting, flashing lights. This embodiment provides a package structure for mounting the semiconductor light-emitting device described in FIG. 10. As shown in FIG. 15, a package substrate 301is provided, which has a planar type or a package body with a recess for mounting the structure of FIG. 10. The package substrate 301 has a conductive line layer. The lower side of the substrate of the structure of FIG. 10 is mounted to the package substrate by an adhesive. The conductive line layer includes at least two portions 302 and 303 insulated from each other for the external connection with the first electrode 113 and the second electrode 114 through wire bonding. Wire-bonding contacts 304 of metal leads are provides on the surfaces of the first electrode 113 and the second electrode 114, and the wire-bonding contacts 304 are generally spherical or ellipsoidal in shape. The wire-bonding contacts 304 are connected to the conductive line layer by the metal leads. The surface of the structure of FIG. 10 may also be covered and sealed with a packaging resin or a packaging resin doped with phosphor.

### Comparative example

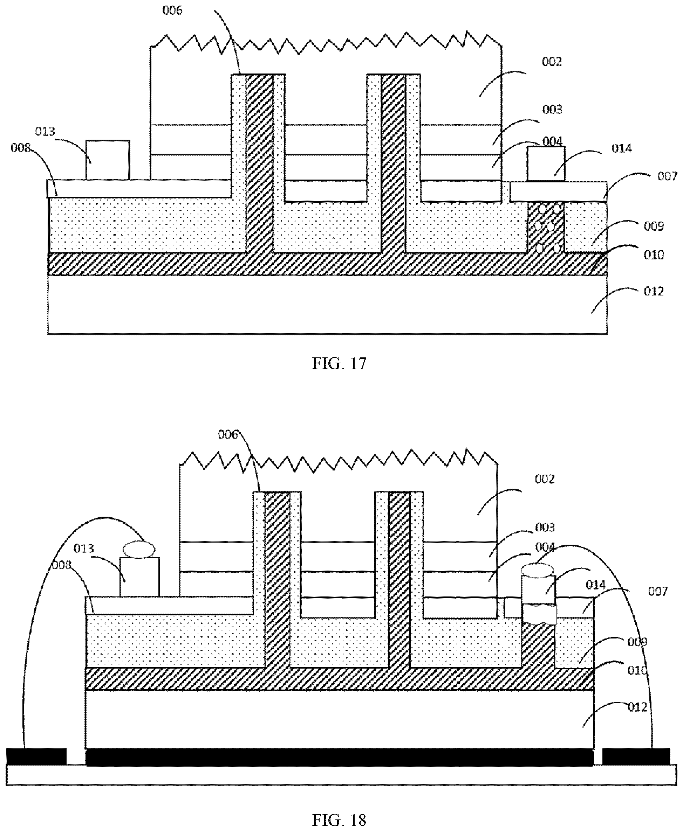

As a comparative example, not forming part of the present invention, the making method of which differs from that of Example 1 in that there is one via 1091 of the insulating layer in the structure shown in FIG. 16, in comparison to the structure in FIG. 7. The via is a column or a cone with unequal area on both sides. A second portion of the second electrical connection layer is filled in the via 1091, and the via of the insulating layer filled by the second portion of the second electrical connection layer is located at the center position below the second electrode. The other process steps of the making method of this comparative example are the same as in Example 1. The obtained semiconductor light-emitting device is shown in Figure 17, and the via in the insulating layer is located at the center position vertically below the second electrode 014. The via structure is filled with the second portion of the second electrical connection layer. The large size of the via and the existence of the height difference result in a lot of voids in the second portion. The semiconductor light-emitting device of this comparative example is made to form a package structure similar to that in Example IV, as shown in FIG. 18. When bonding the wire on the second electrode 014 with an external force, collapse is prone to happen below the second electrode 014, resulting in an abnormal wire bonding for the second electrode.

Due to the height difference of the internal structures of the traditional semiconductor light-emitting device with high current density, voids are easy to appear when an insulating layer is filled with a second electrical connection layer, especially metal or metal alloy. The voids lead to insufficient support when bonding wire for a second electrode, which causes collapse and split of the second electrode. According to the various embodiments of the present invention, the via of the insulating layer vertically below the second electrode is designed to be annular in shape or a multi-via type, so that the insulating layer structure can be retained at the center position vertically below the second electrode and the area near the center position where the wire bonding force is the largest, and the insulating layer forms a strong support for the second electrode against the wire bonding force, replacing the traditional non-dense metal material which is filled in the openings of a columnar via of the insulating layer below the second electrode and serves as a support for wire bonding. So it can thus address the issue of abnormalities such as collapse or split of the second electrode. The via is annular or there are multiple vias, which also improves the denseness of the second electrical connection layer filled into the holes and reduces voids in the metal.

What is mentioned above are only preferred embodiments of the invention, and is not intended to limit the invention. Any modification, equivalent replacement, etc. made within the scope of the invention as defined by the claims, shall be included.

## Claims

1. A semiconductor light-emitting device, comprising:
a substrate (012, 112, 212) and a multi-layer structure stacked on the substrate (012, 112, 212), the multi-layer structure comprising, in order from the substrate side, a second electrical connection layer (010, 110, 210), an insulating layer (009, 109, 209), a first electrical connection layer (008), and a semiconductor light-emitting sequence;
the semiconductor light-emitting sequence comprising a first conductivity type semiconductor layer (004, 104, 204), a light-emitting layer (003, 103, 203) and a second conductivity type semiconductor layer (002, 102, 202) stacked from one side of the first electrical connection layer (008);
a first electrode (013, 113, 213) for external wire bonding, electrically connected to the first conductivity type semiconductor layer (004, 104, 204) by the first electrical connection layer (008);
a second electrode (014, 114, 214) for external wire bonding, electrically connected to the second conductivity type semiconductor layer (002, 102, 202) by the second electrical connection layer (010, 110, 210);
wherein the semiconductor light-emitting sequence, the first electrode (013, 113, 213) and the second electrode (014, 114, 214) are located on the same side of the substrate (012, 112, 212),
wherein the second electrical connection layer (010, 110, 210) comprises a first portion (0101) and a second portion (0102), the first portion (0101) being located at one side of the insulating layer (009, 109, 209) away from the semiconductor light-emitting sequence,
wherein the insulating layer (009, 109, 209) comprises one or more via (1091), the second portion (0102) extending from the first portion (0101) through the one or more via (1091) of the insulating layer (009, 109, 209) to connect with the second electrode (014, 114, 214),
wherein a third electrical connection layer (007), electrically insulated from the first electrical connection layer (008), is provided between the second portion (0102) of the second electrical connection layer (010, 110, 210) and the second electrode (014, 114, 214),
wherein the first electrode (013, 113, 213) is located on the first electrical connection layer (008), at the side opposite to the insulating layer (009, 109, 209),
wherein the second electrode (014, 114, 214) is located on the third electrical connection layer (007) at the side opposite to the insulating layer (009, 109, 209), and
wherein the opening of the one or more via (1091) in the insulating layer (009, 109, 209) is not located at a center position vertically below the second electrode (014, 114, 214), so that the second portion (0102) of the second electrical connection layer (010, 110, 210) that fills in the one or more via (1091) is not located at the center position vertically below the second electrode (014, 114, 214).

2. The semiconductor light-emitting device according to claim 1, **characterized in that**, the one or more via (1091) comprises an annular via (1091), and the second portion (0102) extends through the annular via (1091) to connect with the second electrode (014, 114, 214).

3. The semiconductor light-emitting device according to claim 2, **characterized in that**, the annular via (1091) of the insulating layer (009, 109, 209) is a closed annular via (1091), and a separate insulating layer block (1092) is provided in the closed annular via (1091), a ratio of an area of the separate insulating layer block (1092) to an area of a lower surface of the second electrode (014, 114, 214) being at least 1/4.

4. The semiconductor light-emitting device according to claim 3, **characterized in that**, the ratio of the area of the separate insulating layer block (1092) to the area of the lower surface of the second electrode (014, 114, 214) is at least 1/2, and the two areas are at most equal to each other.

5. The semiconductor light-emitting device according to claim 1, **characterized in that**, the number of the one or more via (1091) is at least two, and the second portion (0102) extends through at least two vias (1091) to connect with the second electrode (014, 114, 214).

6. The semiconductor light-emitting device according to claim 1, **characterized in that**, the insulating layer (009, 109, 209) forms a support and is provided at the center position below the second electrode (014, 114, 214).

7. The semiconductor light-emitting device according to claim 1, **characterized in that**, the ratio of an area under the second electrode (014, 114, 214) to an total area of the via (1091) of the insulating layer (009, 109, 209) is at least 4/5, and the two areas are at most equal to each other.

8. The semiconductor light-emitting device according to claim 1, **characterized in that**, the via (1091) is columnar or conical.

9. The semiconductor light-emitting device according to claim 1, **characterized in that**, the via (1091) of the insulating layer (009, 109, 209) is located closer to an edge relative to the center position vertically below the second electrode (014, 114, 214), or not located vertically below the second electrode (014, 114, 214).

10. The semiconductor light-emitting device according to claim 1, **characterized in that**, an at least half a radius from a center to an edge of a bottom surface of the second electrode (014, 114, 214) overlaps with a surface of the insulating layer (009, 109, 209).

11. The semiconductor light-emitting device according to claim 1, **characterized by** further comprising at least one hole (006) formed in the semiconductor light-emitting sequence, an opening of the hole (006) being located at one side of the first conductivity type semiconductor layer (004, 104, 204), at a bottom of the hole (006) being the second conductivity type semiconductor layer (002, 102, 202), the first electrical connection layer (008) and the insulating layer (009, 109, 209) being located at one side of the first conductivity type semiconductor layer (004, 104, 204) and exposing the opening of the hole, the second electrical connection layer (010, 110, 210) further comprising a third portion (0103) filled in the at least one hole (006) formed in the semiconductor light-emitting sequence, a side wall of the hole (006) being insulated by the insulating layer (009, 109, 209).

12. The semiconductor light-emitting device according to claim 1, **characterized in that**, bottoms of the first electrode (013, 113, 213) and the second electrode (014, 114, 214) are at the same height.

13. The semiconductor light-emitting device according to claim 1, **characterized in that**, the insulating layer (009, 109, 209) has a thickness of 100 nm to 5000 nm between the first electrical connection layer (008) and the second electrical connection layer (010, 110, 210).

14. The semiconductor light-emitting device according to claim 1, **characterized in that**, the insulating layer (009, 109, 209) has a thickness of 500 nm to 5000 nm between the first electrical connection layer (008) and the second electrical connection layer (010, 110, 210).

## Patentansprüche

1. Eine lichtemittierende Halbleitervorrichtung, die Folgendes umfasst:
ein Substrat (012, 112, 212) und eine mehrschichtige Struktur, die auf dem Substrat (012, 112, 212) gestapelt ist, wobei die mehrschichtige Struktur in der Reihenfolge von der Substratseite aus eine zweite elektrische Verbindungsschicht (010, 110, 210), eine Isolierschicht (009, 109, 209), eine erste elektrische Verbindungsschicht (008) und eine lichtemittierende Halbleitersequenz umfasst;
wobei die lichtemittierende Halbleitersequenz eine Halbleiterschicht (004, 104, 204) eines ersten Leitfähigkeitstyps, eine lichtemittierende Schicht (003, 103, 203) und eine Halbleiterschicht (002, 102, 202) eines zweiten Leitfähigkeitstyps umfasst, die von einer Seite der ersten elektrischen Verbindungsschicht (008) aus gestapelt sind;
eine erste Elektrode (013, 113, 213) zum externen Drahtbonden, die durch die erste elektrische Verbindungsschicht (008) elektrisch mit der ersten Halbleiterschicht (004, 104, 204) vom ersten Leitfähigkeitstyp verbunden ist;
eine zweite Elektrode (014, 114, 214) zum externen Drahtbonden, die mit der zweiten Halbleiterschicht (002, 102, 202) des zweiten Leitfähigkeitstyps durch die zweite elektrische Verbindungsschicht (010, 110, 210) elektrisch verbunden ist;
wobei die lichtemittierende Halbleitersequenz, die erste Elektrode (013, 113, 213) und die zweite Elektrode (014, 114, 214) auf der gleichen Seite des Substrats (012, 112, 212) angeordnet sind,
wobei die zweite elektrische Verbindungsschicht (010, 110, 210) einen ersten Abschnitt (0101) und einen zweiten Abschnitt (0102) umfasst, wobei der erste Abschnitt (0101) an einer Seite der Isolierschicht (009, 109, 209) entfernt von der lichtemittierenden Halbleitersequenz angeordnet ist,
wobei die Isolierschicht (009, 109, 209) ein oder mehrere Durchgangslöcher (1091) aufweist, wobei sich der zweite Abschnitt (0102) von dem ersten Abschnitt (0101) durch das eine oder die mehreren Durchgangslöcher (1091) der Isolierschicht (009, 109, 209) erstreckt, um eine Verbindung mit der zweiten Elektrode (014, 114, 214) herzustellen,
wobei eine dritte elektrische Verbindungsschicht (007), die von der ersten elektrischen Verbindungsschicht (008) elektrisch isoliert ist, zwischen dem zweiten Abschnitt (0102) der zweiten elektrischen Verbindungsschicht (010, 110, 210) und der zweiten Elektrode (014, 114, 214) vorgesehen ist,
wobei die erste Elektrode (013, 113, 213) auf der ersten elektrischen Verbindungsschicht (008) auf der der Isolierschicht (009, 109, 209) gegenüberliegenden Seite angeordnet ist,
wobei die zweite Elektrode (014, 114, 214) auf der dritten elektrischen Verbindungsschicht (007) auf der der Isolierschicht (009, 109, 209) gegenüberliegenden Seite angeordnet ist, und wobei die Öffnung des einen oder mehreren Durchgangslöcher (1091) in der Isolierschicht (009, 109, 209) nicht an einer mittleren Position vertikal unterhalb der zweiten Elektrode (014, 114, 214) angeordnet ist, so dass der zweite Abschnitt (0102) der zweiten elektrischen Verbindungsschicht (010, 110, 210), der das eine oder die mehreren Durchgangslöcher (1091) ausfüllt, nicht an der mittleren Position vertikal unterhalb der zweiten Elektrode (014, 114, 214) angeordnet ist.

2. Lichtemittierende Halbleitervorrichtung nach Anspruch 1, **dadurch gekennzeichnet, dass** das eine oder mehrere Durchgangslöcher (1091) ein ringförmiges Durchgangsloch (1091) umfasst und der zweite Abschnitt (0102) sich durch das ringförmige Durchgangsloch (1091) erstreckt, um eine Verbindung mit der zweiten Elektrode (014, 114, 214) herzustellen.

3. Lichtemittierende Halbleitervorrichtung nach Anspruch 2, **dadurch gekennzeichnet, dass** das ringförmige Durchgangsloch (1091) der Isolierschicht (009, 109, 209) ein geschlossenes ringförmiges Durchgangsloch (1091) ist und ein separater Isolierschichtblock (1092) in dem geschlossenen ringförmigen Durchgangsloch (1091) vorgesehen ist, wobei ein Verhältnis einer Fläche des separaten Isolierschichtblocks (1092) zu einer Fläche einer unteren Oberfläche der zweiten Elektrode (014, 114, 214) mindestens 1/4 beträgt.

4. Lichtemittierende Halbleitervorrichtung nach Anspruch 3, **dadurch gekennzeichnet, dass** das Verhältnis der Fläche des separaten Isolierschichtblocks (1092) zu der Fläche der unteren Oberfläche der zweiten Elektrode (014, 114, 214) mindestens 1/2 beträgt und die beiden Flächen höchstens gleich groß sind.

5. Lichtemittierende Halbleitervorrichtung nach Anspruch 1, **dadurch gekennzeichnet, dass** die Anzahl des einen oder der mehreren Durchgangslöcher (1091) mindestens zwei beträgt und der zweite Abschnitt (0102) sich durch mindestens zwei Durchgangslöcher (1091) erstreckt, um eine Verbindung mit der zweiten Elektrode (014, 114, 214) herzustellen.

6. Lichtemittierende Halbleitervorrichtung nach Anspruch 1, **dadurch gekennzeichnet, dass** die einen Träger bildende Isolierschicht (009, 109, 209) in der mittleren Position unterhalb der zweiten Elektrode (014, 114, 214) vorgesehen ist.

7. Lichtemittierende Halbleitervorrichtung nach Anspruch 1, **dadurch gekennzeichnet, dass** das Verhältnis einer Fläche unter der zweiten Elektrode (014, 114, 214) zu einer Gesamtfläche des Durchgangslochs bzw. der Durchgangslöcher (1091) der Isolierschicht (009, 109, 209) mindestens 4/5 beträgt und die beiden Flächen höchstens gleich groß sind.

8. Lichtemittierende Halbleitervorrichtung nach Anspruch 1, **dadurch gekennzeichnet, dass** das Durchgangsloch (1091) säulenförmig oder konisch ist.

9. Lichtemittierende Halbleitervorrichtung nach Anspruch 1, **dadurch gekennzeichnet, dass** das Durchgangsloch (1091) der Isolierschicht (009, 109, 209) näher an einer Kante relativ zur Mittelposition vertikal unterhalb der zweiten Elektrode (014, 114, 214) angeordnet ist oder nicht vertikal unterhalb der zweiten Elektrode (014, 114, 214) angeordnet ist.

10. Lichtemittierende Halbleitervorrichtung nach Anspruch 1, **dadurch gekennzeichnet, dass** ein mindestens halber Radius von einer Mitte zu einer Kante einer Bodenfläche der zweiten Elektrode (014, 114, 214) mit einer Oberfläche der Isolierschicht (009, 109, 209) überlappt.

11. Lichtemittierende Halbleitervorrichtung nach Anspruch 1, **dadurch gekennzeichnet, dass** sie ferner mindestens ein Loch (006) umfasst, das in der lichtemittierenden Halbleitersequenz ausgebildet ist, wobei eine Öffnung des Lochs (006) an einer Seite der Halbleiterschicht (004, 104, 204) des ersten Leitfähigkeitstyps angeordnet ist, wobei sich an einem Boden des Lochs (006) die Halbleiterschicht (002, 102, 202) des zweiten Leitfähigkeitstyps befindet, wobei die erste elektrische Verbindungsschicht (008) und die Isolierschicht (009, die erste elektrische Verbindungsschicht (008) und die Isolierschicht (009, 109, 209) an einer Seite der Halbleiterschicht (004, 104, 204) des ersten Leitfähigkeitstyps angeordnet sind und die Öffnung des Lochs freilegen, wobei die zweite elektrische Verbindungsschicht (010, 110, 210) ferner einen dritten Abschnitt (0103) aufweist, der in das mindestens eine Loch (006) gefüllt ist, das in der lichtemittierenden Halbleitersequenz ausgebildet ist, wobei eine Seitenwand des Lochs (006) durch die Isolierschicht (009, 109, 209) isoliert ist.

12. Lichtemittierende Halbleitervorrichtung nach Anspruch 1, **dadurch gekennzeichnet, dass** die Böden der ersten Elektrode (013, 113, 213) und der zweiten Elektrode (014, 114, 214) auf der gleichen Höhe liegen.

13. Lichtemittierende Halbleitervorrichtung nach Anspruch 1, **dadurch gekennzeichnet, dass** die Isolierschicht (009, 109, 209) eine Dicke von 100 nm bis 5000 nm zwischen der ersten elektrischen Verbindungsschicht (008) und der zweiten elektrischen Verbindungsschicht (010, 110, 210) aufweist.

14. Lichtemittierende Halbleitervorrichtung nach Anspruch 1, **dadurch gekennzeichnet, dass** die Isolierschicht (009, 109, 209) eine Dicke von 500 nm bis 5000 nm zwischen der ersten elektrischen Verbindungsschicht (008) und der zweiten elektrischen Verbindungsschicht (010, 110, 210) aufweist.

## Revendications

1. Dispositif semi-conducteur d'émission de lumière, comprenant :
un substrat (012, 112, 212) et une structure multicouche empilée sur le substrat (012, 112, 212), la structure multicouche comprenant, dans l'ordre à partir du côté du substrat, une deuxième couche de connexion électrique (010, 110, 210), une couche isolante (009, 109, 209), une première couche de connexion électrique (008), et une séquence semi-conductrice d'émission de lumière ;
la séquence semi-conductrice d'émission de lumière comprend une couche semi-conductrice du premier type de conductivité (004, 104, 204), une couche électroluminescente (003, 103, 203) et une couche semi-conductrice du deuxième type de conductivité (002, 102, 202) empilées d'un côté de la première couche de connexion électrique (008) ;
une première électrode (013, 113, 213) pour le câblage externe, reliée électriquement à la couche semi-conductrice du premier type de conductivité (004, 104, 204) par la première couche de connexion électrique (008) ;
une deuxième électrode (014, 114, 214) pour le câblage externe, reliée électriquement à la couche semi-conductrice du deuxième type de conductivité (002, 102, 202) par la deuxième couche de connexion électrique (010, 110, 210) ;
dans lequel la séquence semi-conductrice d'émettrice de lumière, la première électrode (013, 113, 213) et la deuxième électrode (014, 114, 214) sont situées du même côté du substrat (012, 112, 212),
la seconde couche de connexion électrique (010, 110, 210) comprend une première partie (0101) et une seconde partie (0102), la première partie (0101) étant située sur un côté de la couche isolante (009, 109, 209), à l'écart de la séquence semi-conductrice d'émettrice de lumière,
dans laquelle la couche isolante (009, 109, 209) comprend un ou plusieurs via (1091), la deuxième partie (0102) s'étendant depuis la première partie (0101) à travers le ou les via (1091) de la couche isolante (009, 109, 209) pour se connecter à la deuxième électrode (014, 114, 214),
dans lequel une troisième couche de connexion électrique (007), isolée électriquement de la première couche de connexion électrique (008), est prévue entre la deuxième partie (0102) de la deuxième couche de connexion électrique (010, 110, 210) et la deuxième électrode (014, 114, 214),
la première électrode (013, 113, 213) est située sur la première couche de connexion électrique (008) du côté opposé à la couche isolante (009, 109, 209),
dans laquelle la deuxième électrode (014, 114, 214) est située sur la troisième couche de connexion électrique (007) du côté opposé à la couche isolante (009, 109, 209), et
dans lequel l'ouverture d'un ou plusieurs via (1091) dans la couche isolante (009, 109, 209) n'est pas située à une position centrale verticalement en dessous de la deuxième électrode (014, 114, 214), de sorte que la deuxième partie (0102) de la deuxième couche de connexion électrique (010, 110, 210) qui remplit un ou plusieurs via (1091) n'est pas située à la position centrale verticalement en dessous de la deuxième électrode (014, 114, 214).

2. Le dispositif semi-conducteur d'émission de lumière selon la revendication 1, **caractérisé en ce que** le ou les via (1091) comprennent un via annulaire (1091), et la deuxième partie (0102) s'étend à travers le via annulaire (1091) pour se connecter à la deuxième électrode (014, 114, 214).

3. Le dispositif semi-conducteur d'émission de lumière selon la revendication 2, **caractérisé en ce que** le via annulaire (1091) de la couche isolante (009, 109, 209) est un via annulaire fermé (1091), et un bloc de couche isolante séparé (1092) est prévu dans le via annulaire fermé (1091), un rapport d'une surface du bloc de couche isolante séparé (1092) à une surface d'une surface inférieure de la deuxième électrode (014, 114, 214) étant d'au moins 1/4.

4. Le dispositif semi-conducteur d'émission de lumière selon la revendication 3, **caractérisé en ce que** le rapport entre la surface du bloc de couche isolante séparée (1092) et la surface de la face inférieure de la deuxième électrode (014, 114, 214) est d'au moins 1/2, et les deux surfaces sont au plus égales l'une à l'autre.

5. Le dispositif semi-conducteur d'émission de lumière selon la revendication 1, **caractérisé en ce que** le nombre d'un ou plusieurs via (1091) est au moins deux, et la deuxième partie (0102) s'étend à travers au moins deux vias (1091) pour se connecter à la deuxième électrode (014, 114, 214).

6. Le dispositif semi-conducteur d'émission de lumière selon la revendication 1, **caractérisé en ce que** la couche isolante (009, 109, 209) formant un support est prévue en position centrale sous la seconde électrode (014, 114, 214).

7. Le dispositif semi-conducteur d'émission de lumière selon la revendication 1, **caractérisé en ce que** le rapport d'une surface sous la deuxième électrode (014, 114, 214) à une surface totale du via (1091) de la couche isolante (009, 109, 209) est d'au moins 4/5, et les deux surfaces sont au plus égales l'une à l'autre.

8. Le dispositif semi-conducteur d'émission de lumière selon la revendication 1, **caractérisé par le fait que** le via (1091) est colonnaire ou conique.

9. Le dispositif semi-conducteur d'émission de lumière selon la revendication 1, **caractérisé en ce que** le via (1091) de la couche isolante (009, 109, 209) est situé plus près d'un bord par rapport à la position centrale verticalement au-dessous de la deuxième électrode (014, 114, 214), ou n'est pas situé verticalement au-dessous de la deuxième électrode (014, 114, 214).

10. Le dispositif semi-conducteur d'émission de lumière selon la revendication 1, **caractérisé en ce qu'**un rayon d'au moins la moitié d'un centre à un bord d'une surface inférieure de la deuxième électrode (014, 114, 214) chevauche une surface de la couche isolante (009, 109, 209).

11. Le dispositif semi-conducteur d'émission de lumière selon la revendication 1, **caractérisé en ce qu'**il comprend en outre au moins un trou (006) formé dans la séquence semi-conductrice d'émission de lumière, une ouverture du trou (006) étant située sur un côté de la couche semi-conductrice du premier type de conductivité (004, 104, 204), sur un fond du trou (006) étant la couche semi-conductrice du deuxième type de conductivité (002, 102, 202), la première couche de connexion électrique (008) et la couche d'isolation (009, 109, 209) étant situées sur un côté de la couche semi-conductrice du premier type de conductivité (004, 104, 204) et exposant l'ouverture du trou, la deuxième couche de connexion électrique (010, 110, 210) comprenant en outre une troisième partie (0103) remplie dans l'au moins un trou (006) formé dans la séquence semi-conductrice d'émission de lumière, une paroi latérale du trou (006) étant isolée par la couche isolante (009, 109, 209).

12. Le dispositif semi-conducteur d'émission de lumière selon la revendication 1, **caractérisé en ce que** les fonds de la première électrode (013, 113, 213) et de la deuxième électrode (014, 114, 214) sont à la même hauteur.

13. Le dispositif semi-conducteur d'émission de lumière selon la revendication 1, **caractérisé en ce que** la couche isolante (009, 109, 209) a une épaisseur de 100 nm à 5000 nm entre la première couche de connexion électrique (008) et la seconde couche de connexion électrique (010, 110, 210).

14. Le dispositif semi-conducteur d'émission de lumière selon la revendication 1, **caractérisé en ce que** la couche isolante (009, 109, 209) a une épaisseur de 500 nm à 5000 nm entre la première couche de connexion électrique (008) et la seconde couche de connexion électrique (010, 110, 210).
